# EUROPEAN PATENT APPLICATION

(11) **EP 0 989 640 A2**
(43) Date of publication of application: **29.03.2000**
(21) Application number: 99307433.5
(22) Date of filing: 20.09.1999
(51) Int. Cl.: H01S 3/11

(54) **Q-switched laser apparatus**

(30) Priority: 21.09.1998 JP 28478198
(71) Applicant: Miyachi Technos Corporation, Noda-shi, Chiba-ken (JP)
(72) Inventor: Murata, Shingo, Noda-shi, Chiba-ken (JP)
(74) Representative: Spall, Christopher John

(57) **Abstract**

A storage time measurement unit 46 accepts as time measurement timing signals a reference pulse CP from a Q switch control unit and a high-frequency oscillation control signal ec from a sequence control unit 42, to measure the storage time corresponding to each reference pulse. A pulse order count unit 48 accepts a reference pulse CP as a count object signal from the Q switch control unit and a Q-switching control signal qc as a count period control signal from the sequence control unit 42, to count the order of each reference pulse in a pulse train. On a reference pulse CP₍ᵢ₎ basis, a degree of modulation control unit 50 receives storage time measurement data T_{G(i)} and order value count data <i> fed respectively from the storage time measurement unit 46 and the pulse order count unit 48, and based on the above measurement data T_{G(1)}, <i> and on a desired setting value (a fixed value) from a setting unit, computes the degree of modulation [MD] corresponding to that reference pulse CP₍ᵢ₎. Then, a degree of modulation control signal mc corresponding to the thus obtained degree of modulation [MD] is imparted to the Q switch control unit.

## Description

### BACKGROUND OF THE INVENTION

### 1. Field of the Invention

The present invention relates to a Q-switched laser apparatus providing an oscillatory output of Q-switched pulsed laser beam.

### 2. Description of the Related Arts

By use of Q switch, solid-state laser apparatuses such as YAG laser apparatuses make it possible to convert continuous oscillations into high-speed repetition pulse oscillations with high peak powers (peak outputs) . The YAG laser apparatuses typically use an acousto-optic Q switch utilizing Bragg diffraction of ultrasonic wave.

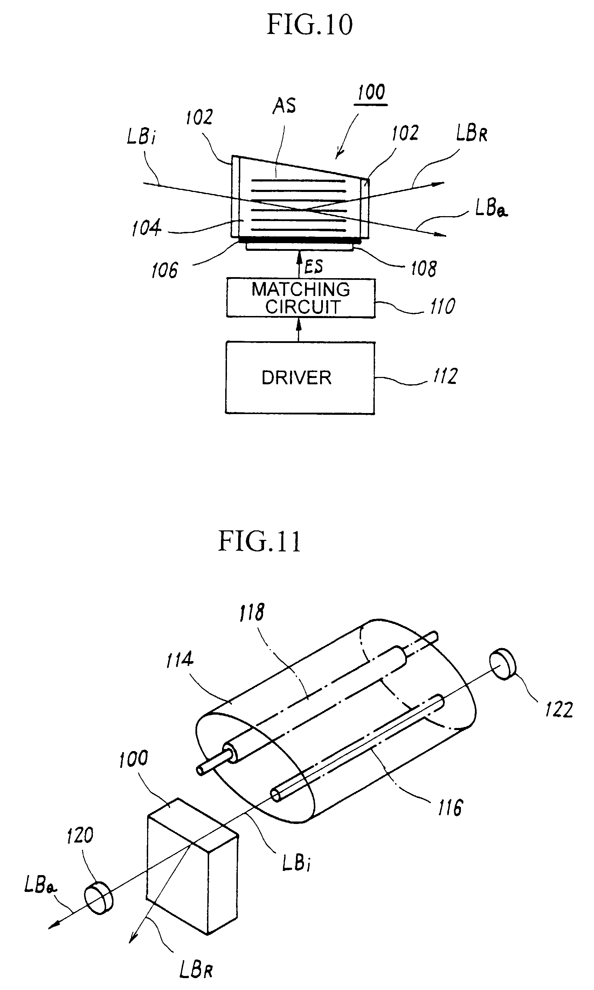

As depicted in Fig. 10, the acousto-optic Q switch generally designated at 100 comprises a synthetic quartz glass 104 acting as a polarizing medium whose incident and exit surfaces are coated with antireflection film 102, a piezoelectric element 108 for ultrasonic generation coupled via an adhesive layer 106 to one surface (bottom surface) of the quartz glass 104, and a high-frequency matching circuit 110.

When 24MHz, 50W high-frequency electric signals ES for example are fed from the Q switch driver 112 via the matching circuit 110 to the piezoelectric element 108, the high-frequency electric signals ES are converted by piezoelectric effect into ultrasonic waves AS, which in turn transmit through the interior of the quartz glass 104. Then, photoelastic effect gives rise to a periodical distribution of refractive index within the quartz glass 104, on which beams of light LBᵢ impinge at an appropriate angle so that the incident beams of light LBᵢ are diffracted as LB_{R} (acousto-optic effect).

Fig. 11 illustrates a configuration of a Q-switched YAG laser oscillator. A YAG rod 116 and an excitation lamp 118 are positioned in parallel with each other at a pair of elliptical focal points within an elliptical reflector cylinder 114. An output mirror 120 and a total reflection mirror 122 confront both end surfaces of the YAG rod 116, with a Q switch 100 being interposed between one end surface of the YAG rod 116 and the output mirror 120.

As described hereinabove, once the high-frequency electric signals ES are fed to the Q switch 100 to allow the ultrasonic waves AS to transmit through the interior of the quartz glass 104, part of the laser beams from the YAG rod 116 is diffracted by the Q switch 100, so that the loss of the laser oscillator increases and the Q-value reduces, bringing the laser oscillation to a stop.

Regardless of the stop of the laser oscillation, however, the excitation of the YAG rod 116 by the excitation lamp 118 will continue, whereupon the excitation energy within the laser oscillator builds up and becomes stored. Then, if when the thus stored excitation energy has become sufficiently large, the high-frequency electric signals ES are shut off to rapidly restore the Q-value, pulse oscillation will take place within the laser oscillator, resulting in an acquisition of Q-switched pulsed laser beams LB_{Q} with extremely high peak powers (peak outputs).

In the actual application, the Q switch 100 is fed with high-frequency electric signals ES which have been modulated by the modulation pulses having arbitrary repetitive frequencies, and the supply of the high-frequency electric signals ES is temporarily interrupted for the duration of each modulation pulse, thereby acquiring Q-switched pulsed laser beams LB_{Q} in synchronism with the modulation pulses.

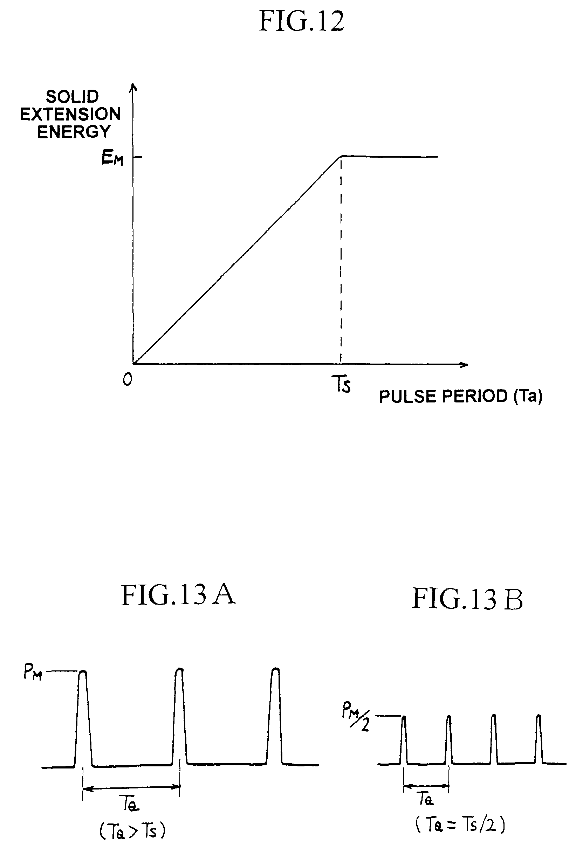

Referring to Fig. 12, the amount of the excitation energy stored in the laser oscillator immediately before the execution of the Q-switched pulse oscillation is proportional to the pulse intervals or period T_{Q} of the modulation pulses, so that it increases accordingly as the pulse period T_{Q} becomes longer, but when exceeding the saturation reference time T_{S} (e.g., 500 µs), it is saturated at a certain value E_{M}.

Thus, the peak powers of the Q-switched pulsed laser beams LB_{Q} will coincide with the maximum or saturation level P_{M} when the pulse period T_{Q} is equal to or longer than T_{S} as shown in Fig. 13A, whereas they will result in the level obtained by multiplying the maximum level P_{M} by the ratio of T_{Q} to T_{S} (T_{Q}/ T_{S}) when the pulse period T_{Q} is shorter than T_{S} as shown in Fig. 13B.

In the actual application, the above Q-switched laser oscillator often performs its Q-switched action at a shorter period T_{Q} than the reference time T_{S}.

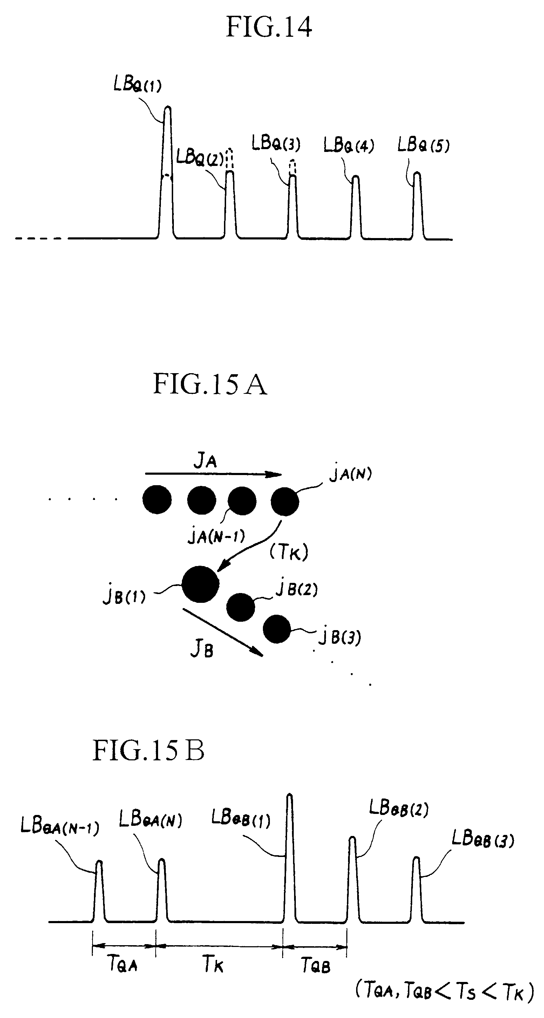

In such a case, as shown in Fig. 14, there may arise a problem that a first Q-switched pulsed laser beam immediately after the power-on or immediately after the restart of the Q-switched, a so-called first pulse LB_{Q(1)} may have a peak power level extraordinarily higher than that of the other (following) Q-switched pulsed laser beams LB_{Q(2)}, LB_{Q(3)}, etc.

This is attributable to the fact that the first pulse immediately after the power-on or restart of the laser oscillation output is subjected to Q-switched under the state where the amount of storage of the excitation energy is at the saturation level E_{M}, whereas in the steady state the Q-switched is performed before the amount of storage of the excitation energy within the laser oscillator reaches the saturation level E_{M} (at the period shorter than the saturation reference time T_{S}).

In the case of precise laser processing, such a protruding peak power of the first pulse LB_{Q(1)} may be an obstacle to processing quality.

For example, in the laser marking processing, when the marking processing point jumps from a line (stroke) J_{A} to a next line (stroke) J_{B} as shown in Fig. 15A, there may be a large time interval T_{K} in the Q-switched between the terminating point j_{A(N)} of J_{A} and the initiating point j_{B(1)} of J_{B}.

In such a case, if the pulse period T_{Q} is shorter than T_{S} during the plotting of the two strokes J_{A} and J_{B}, then as shown in Fig. 15B, the Q-switched pulsed laser beam corresponding to the initiating point J_{B(1)}, that is, the first pulse LB_{QB(1)} will have a peak power extraordinarily higher than that of the other Q-switched pulsed laser beams, LB_{QA(N-1)}, LB_{QA(N)}, LB_{QB(2)}, LO_{BQ(3)}, etc., with the result that the dot size of the initiating point j_{B(1)} may become extraordinarily larger than the dot size of the other plotting points j_{A(N-1)}, j_{A(N)}, j_{B(2)}, j_{B(3)}, etc., causing a deterioration in the marking quality.

In order to deal with such deficiencies, a method is conceivable in which the degree of modulation (degree of reduction or attenuation of amplitude) of the first pulse is appropriately reduced so that its peak power is suppressed and coincides with the peak powers in the steady state.

Typically, however, it would be difficult for a single first pulse LB_{Q(1)} to release all the excitation energy stored, with the result that the remaining excitation energy may migrate to the following Q-switched pulsed laser beams LB_{Q(2)}, LB_{Q(3)}, etc., and a phenomenon is apt to occur in which their peak powers protrude as indicated by broken lines in Fig. 14.

In addition, this phenomenon may vary depending on the storage time lasting till the oscillatory output of the first pulse LB_{Q(1)} or on the pulse period (Q-switched period) T_{Q}. More specifically, the degree or extent of the excitation energy which may migrate from the first pulse LB_{Q(1)} to the following pulses LB_{Q(2)}, LB_{Q(3)}, etc., will be greater when there is some elapsed time after the storage time has exceeded the saturation reference time T_{S}, than immediately after the time T_{S} has been exceeded, or at a shorter pulse period T_{Q}.

In the past, setting was carried out in a repeated trial and error manner to impart an appropriate variation to the degree of modulation of each Q-switched pulsed laser beam. However, this method could not deal with any actual applications. For example, in the above laser marking processing, the Q-switched interruption time T_{K} between different strokes is not always unvarying but rather may largely vary depending on the plotting pattern, so that it would be difficult for setting of modulation in a repeated trial and error manner or for the fixed modulation control to deal with such situations. For this reason, it would extremely be difficult to provide oscillatory outputs of the Q-switched pulsed laser beams with uniform peak powers to thereby achieve uniform dot plotting.

### SUMMARY OF THE INVENTION

The present invention was conceived in view of the above problems. It is therefore the object of the present invention to provide a Q-switched laser apparatus ensuring an optimum modulation control in accordance with the actual storage amount of excitation energy within the laser oscillator.

In order to solve the above problems, according to a first aspect of the present invention there is provided a Q-switched laser apparatus comprising a laser oscillator including a Q switch; a power supply for supplying electric power for continuous oscillation to the laser oscillator; high-frequency oscillation means for generating a high-frequency electric signal at a fixed frequency; reference pulse generation means for generating a modulation reference pulse having a desired repetition frequency for modulating the high-frequency electric signal; storage time measurement means for measuring, as excitation energy storage time for Q-switched pulse oscillation in the laser oscillator, the time during which the high-frequency electric signal keeps its amplitude at a steady level till the start of the pulse duration of a predetermined modulation reference pulse generated by the reference pulse generation means; degree of modulation calculation means for computing the degree of modulation corresponding to the predetermined modulation reference pulse on the basis of the storage time measured by the storage time measurement means; modulation means for modulating the high-frequency electric signal on the basis of the modulation reference pulse and in conformity with the degree of modulation computed by the degree of modulation calculation means; and Q switch driver means for driving the Q switch in response to the modulated high-frequency electric signal, to cause the laser oscillator to oscillate and output a Q-switched pulsed laser beam in synchronism with the modulation reference pulse and having a peak power in conformity with the degree of modulation.

According to a second aspect of the present invention there is provided a Q-switched laser apparatus comprising a laser oscillator including a Q switch; a power supply for supplying electric power for continuous oscillation to the laser oscillator; high-frequency oscillation means for generating a high-frequency electric signal at a fixed frequency; reference pulse generation means for generating a modulation reference pulse having a desired repetition frequency for modulating the high-frequency electric signal; storage time measurement means for measuring, as excitation energy storage time for Q-switched pulse oscillation in the laser oscillator, the time during which the high-frequency electric signal keeps its amplitude at a steady level till the start of the pulse duration of a predetermined modulation reference pulse generated by the reference pulse generation means; pulse order count means for counting the order of the predetermined modulation reference pulse in an equi-time-interval pulse train; degree of modulation calculation means for computing the degree of modulation corresponding to the predetermined modulation reference pulse on the basis of the storage time measured by the storage time measurement means and of the order counted by the pulse order count means; modulation means for modulating the high-frequency electric signal on the basis of the modulation reference pulse and in conformity with the degree of modulation computed by the degree of modulation calculation means; and Q switch driver means for driving the Q switch in response to the modulated high-frequency electric signal, to cause the laser oscillator to oscillate and output a Q-switched pulsed laser beam in synchronism with the modulation reference pulse and having a peak power in conformity with the degree of modulation.

In the Q-switched laser apparatus according to the first or second aspect, the storage time measurement means may include first timer means for measuring elapsed time from the feed starting point of the high-frequency electric signal up to the leading start point of the first fed modulation reference pulse; and second timer means for measuring elapsed time, between the two consecutive modulation reference pulses being fed during the feed of the high-frequency electric signal, from the trailing end point of the preceding modulation reference pulse up to the leading end point of the following modulation reference pulse.

Alternatively, in the Q-switched laser apparatus according to the first or second aspect, the modulation means may include modulation pulse generation means for generating a modulation pulse in synchronism with the modulation reference pulse, the modulation pulse having at its leading edge an upslope gradient in conformity with the degree of modulation; and amplitude modulation means for modulating the amplitude of the high-frequency electric signal by the modulation pulse.

Preferably, in the Q-switched laser apparatus according to the first or second aspect, the modulation means may include modulation pulse generation means for generating a modulation pulse in synchronism with the modulation reference pulse, the modulation pulse having an amplitude in conformity with the degree of modulation; and amplitude modulation means for modulating the amplitude of the high-frequency electric signal by the modulation pulse.

According to the Q-switched laser apparatus of the present invention as set forth hereinabove, measurement is made of the excitation energy storage time taken for the start of each Q-switched, on the basis of which storage time the degree of modulation of the Q-switched is controlled whereby optimum control of modulation can be provided depending on the actual amount of storage of the excitation energy within the laser oscillator.

### BRIEF DESCRIPTION OF THE DRAWINGS

The above and other objects, aspects, features and advantages of the present invention will become more apparent from the following detailed description with reference to the accompanying drawings, in which:
Fig. 1 is a block diagram showing a configuration of the major part of a Q-switched YAG laser processing apparatus for scanning marking in accordance with an embodiment of the present invention;
Fig. 2 is a block diagram showing a configuration of a Q switch control unit in the embodiment;
Figs. 3A to 3E are waveform diagrams showing waveforms of signals appearing at respective parts for explaining the functions of a pulse generator, a pulse shaping circuit and a modulation pulse generation circuit in the Q-switched control unit of the embodiment;
Figs. 4A to 4C are waveform diagrams for explaining a basic modulation control method which is the basis of the Q-switching modulation control in the embodiment;
Figs. 5A to 5C are waveform diagrams for explaining a basic modulation control method which is the basis of the Q-switching modulation control in the embodiment;
Fig. 6 is a block diagram showing a functional configuration of a main control unit providing the Q-switching modulation control of the embodiment;
Fig. 7 is a diagram showing transitions between two consecutive strokes in the laser marking of the embodiment;
Figs. 8A to 8C are waveform diagrams showing waveforms appearing at respective parts corresponding to patterns of Fig. 7 in the embodiment;
Figs. 9A to 9C are waveform diagrams showing a variant of the basic Q-switching modulation control method in the embodiment;
Fig. 10 is a diagram showing a configuration of the acousto-optic Q switch;
Fig. 11 is a perspective view showing a configuration of a Q-switched YAG laser oscillator;
Fig. 12 illustrates a relationship between the cycle of pulse and the amount of storage of excitation energy in the Q-switched laser apparatus;
Figs. 13A and 13B illustrate relationships between the cycle of pulse and the peak power of the Q-switched pulsed laser beam in the Q-switched laser apparatus;
Fig. 14 is a diagram showing a phenomenon in which the peak powers of the first pulse, second pulse, etc., extraordinarily protrude in the Q-switched solid-state laser;
Figs. 15A and 15B are diagrams showing that the phenomenon of Fig. 14 may result in a deficiency in the laser marking processing.

### DESCRIPTION OF THE PREFERRED EMBODIMENT

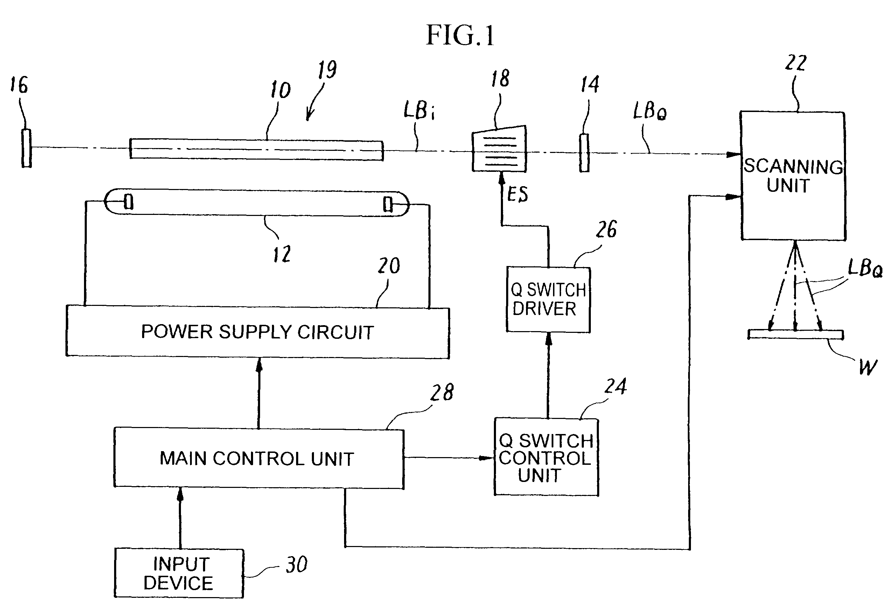

The present invention will now be described with reference to Figs. 1 to 9, which illustrate a preferred embodiment of the present invention in a non-limitative manner.

Fig. 1 shows a configuration in major part of a Q-switched YAG laser processing apparatus for scanning marking in accordance with the embodiment of the present invention.

The YAG laser processing apparatus of the present invention comprises a YAG rod 10, an excitation lamp 12, an output mirror 14, a total reflection mirror 16 and a Q switch 18, all of which constitute a YAG laser oscillator 19 similar to that shown in Fig. 11.

The excitation lamp 12 receives a supply of electric power for continuous oscillation from a power supply circuit 20, to provide a continuous emission of light. The YAG rod 10 is excited by a substantially constant beam of light emitted from the excitation lamp 12 and issues a substantially constant beam of light from its both end surfaces in the axial direction.

When impartment of a high-frequency electric signal ES to the Q switch 18 is ceased, beams of light issued from the both end surfaces of the YAG rods 10 are iteratively reflected through the Q switch 18 between the output mirror 14 and the total reflection mirror 16 for resonant amplification, after which the beams of light pass through the output mirror 14 in the axial direction in the form of a Q-switched pulsed laser beam LB_{Q}. The Q-switched pulsed laser beam LB_{Q} output from the output mirror 14 is transmitted through a transmission optical system not shown consisting of, e.g., mirrors or optical fibers to a scanning unit 22.

The scanning unit 22 incorporates therein an optical scanning mechanism for scanning a beam spot of the Q-switched pulsed laser beam LB_{Q} in a desired plotting pattern on a material W to be processed, and a scanning drive circuit.

The Q switch 18 can be an acousto-optic Q switch having the same configuration and functions as that shown in Fig. 10. Thus, this Q switch 18 serves to diffract an incident laser beam LBᵢ from the YAG rod 10 by means of acousto-optic effect (i.e., to thereby lower its Q value) in order to store and build up the excitation energy (population inversion) within a resonator during the time when the Q switch 18 is supplied with the high-frequency electric signal ES from a Q switch driver 26 under the control of a Q switch control unit 24, whereas when the supply of the high-frequency electric signal ES is shut off, the Q switch 18 permits the incident laser beam LBᵢ to advance straight (to restore its Q value) so that the laser oscillation can be done at one stroke by the built-up excitation energy, allowing the Q-switched pulsed laser beam LB_{Q} to be generated.

A main control unit 28 is comprised of a microcomputer and serves to provide control of actions of various parts including the power supply circuit 20, the scanning unit 22 and the Q switch control unit 24 in compliance with desired programs stored in the built-in memory or with various setting values, commands or the like entered through an input device 30.

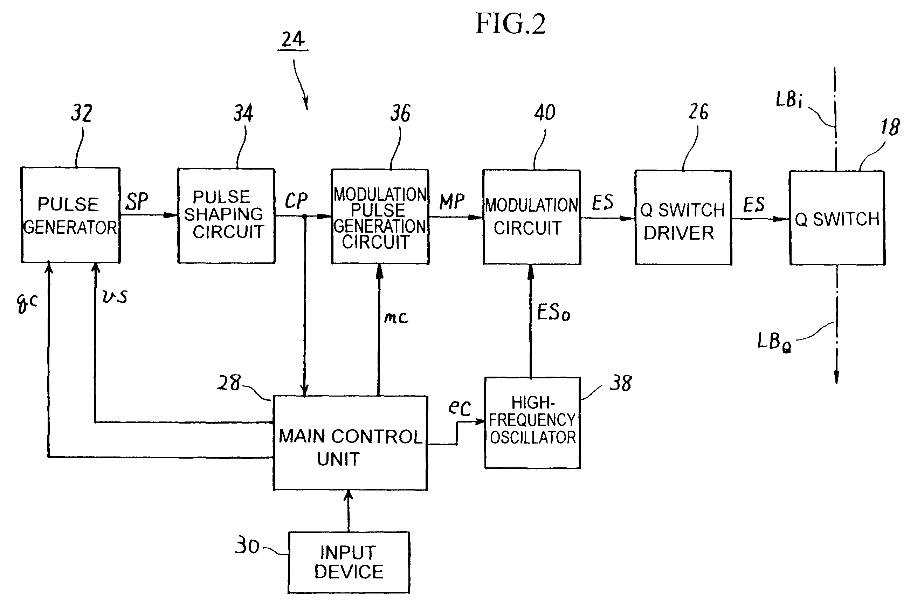

Fig. 2 shows a circuit configuration of the Q switch control unit 24 in this embodiment. The Q switch control unit 24 includes a pulse generator 32, a pulse shaping circuit 34, a modulation pulse generation circuit 36, a high-frequency oscillator 38 and a modulation circuit 40.

The pulse generator 32 is comprised of, e.g., a V-F (voltage to frequency) converter, which receives a Q-switching control signal qc and a frequency control voltage vs from the main control unit 28 and which generates a pulse SP at a repetition frequency proportional to the voltage level of the repetition frequency control voltage vs for the duration when qc is active (e.g., high level).

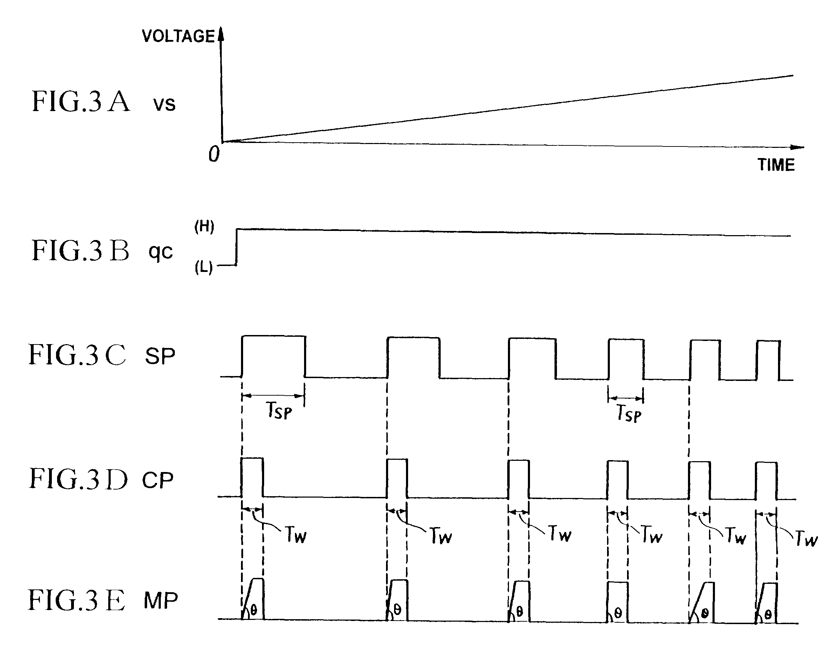

As depicted diagrammatically in Fig. 3C, the pulse SP generated by the pulse generator 32 has a pulse width T_{SP} which varies in inverse proportion to the repetition frequency. More specifically, a lower repetition frequency results in a greater pulse width T_{SP}, whereas a higher repetition frequency results in a smaller pulse width T_{SP}.

The pulse shaping circuit 34 is provided in the form of e.g., a one-shot multivibrator, which receives a pulse SP from the pulse generator 32 and which issues a pulse CP having a certain pulse width T_{W} in response to the leading edge of the pulse SP and having a certain amplitude as shown in Figs. 3C and 3D.

In this embodiment the pulse generator 32 and the pulse shaping circuit 34 make up reference pulse generation means to output the pulse CP having a certain pulse width issued from the pulse shaping circuit 34 as a modulation reference pulse.

In Fig. 3A the level of the repetition frequency control voltage vs for the pulse generator 32 is monotonically increased with time for the purpose of explaining the functions of the reference pulse generation means in this embodiment, although in the actual application the frequency control voltage vs is maintained at a certain voltage level corresponding to the setting value of the repetition frequency (Q-switching frequency) of the Q-switched pulsed laser beam LB_{Q}.

The modulation pulse generation circuit 36 receives a pulse CP from the pulse shaping circuit 34 and generates a pulse MP for modulation in synchronism with the pulse CP and having an upslope gradient θ in compliance with a degree of modulation control signal mc from the main control unit 28 as depicted diagrammatically in Figs. 3D and 3E.

The modulation circuit 40 receives the modulation pulse MP from the modulation pulse generation circuit 36 and receives a carrier wave in the form of a high-frequency electric signal ESₒ successively output from the high-frequency oscillator 38 at e.g., 24 MHz and 50W, to modulate the amplitude of the high-frequency electric signal ESₒ by the modulation pulse MP to consequently generate a high-frequency electric signal ES for Q-switched.

In this embodiment, the modulation means are made up of the modulation pulse generation circuit 36 and the modulation circuit 40.

It will be appreciated that the high-frequency oscillator 38 conducts on-off control of the high-frequency electric signal ESₒ based on a high-frequency oscillation control signal ec from the main control unit 28 in order to ensure that the high-frequency electric signal ESₒ is issued only for the duration when the signal ec is active (high) for example.

The Q switch driver 26 can be a power amplifier type of driver circuit having the same configuration and functions as that shown in Fig. 10, which serves to amplify the power of the high-frequency electric signal ES from the modulation circuit 40 and to drive the Q switch 18 by means of the thus amplified high-frequency electric signal.

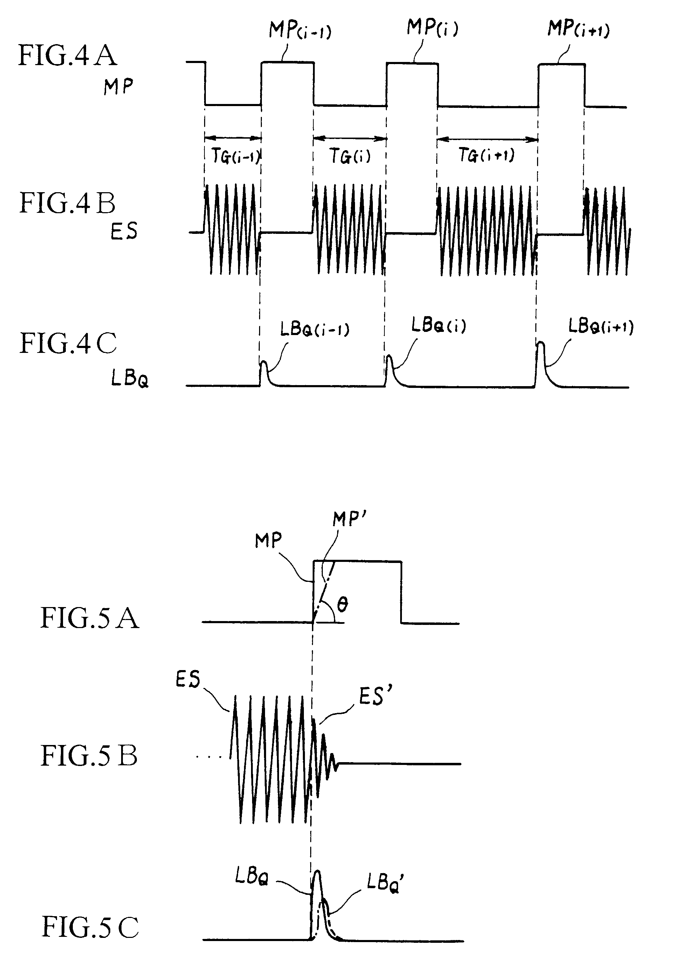

Referring now to Figs. 4A to 4C and 5A to 5C, a basic modulation control method will be described which is the basis of the Q-switching modulation control in this embodiment.

As can be seen from Figs. 4A, 4B and 4C, when the modulation circuit 40 receives a modulation pulse MP in the form of a rectangular waveform having a voltage exceeding a predetermined level, there is obtained a high-frequency electric signal ES with a fixed amplitude, which has on-periods corresponding to the low level of the modulation pulse MP and has off-periods (completely shut-off periods) corresponding to the high level of the modulation pulse MP. Once the Q switch 18 is operated by this high-frequency electric signal ES, the laser oscillator 19 gives rise to Q-switched pulse oscillations at the beginning of the off periods, allowing the output mirror 14 to output the Q-switched pulsed laser beam LB_{Q}.

If the laser oscillator 19 is supplied with a constantly unvaried power for continuous oscillation from the power supply circuit 20, the peak power of each Q-switched pulsed laser beam LB_{Q(1)} will be proportional to the on-period of the high-frequency electric signal ES precedent to each corresponding modulation pulse MP₍ᵢ₎, that is, to the excitation energy storage time TG₍ᵢ₎ defined by the elapsed time from the trailing end of the most recent modulation pulse HP_{(i -1)} up to the leading start point of the current modulation pulse MP₍ᵢ₎. It is to be noted that if this storage time TG₍ᵢ₎ exceeds the reference time Ts, the peak power will remain at a predetermined saturation level.

Various methods are known to those skilled in the art for providing arbitrary variable control of the peak power of the Q-switched pulsed laser beam LB_{Q} under such a given pulse separation or pulse period. One of them is a method as shown in Figs. 5A to 5C, in which instead of instantaneously raising the modulation pulse MP from low level to high level, it is fashioned into an upslope waveform (MP') having an appropriate inclination or gradient θ in order to ensure that the amplitude of the high-frequency electric signal ES becomes gradually attenuated (ES') into zero.

According to this method there will occur a Q-switched pulse oscillation (LB_{Q'}) at the time when the amplitude of the high-frequency electric signal ES has become smaller than a certain threshold value. The smaller the upslope gradient θ in the leading edge of the pulse signal (MP') is, the more time will be required for the amplitude of the high-frequency electric signal (ES') to become smaller than the threshold value (that is, the larger the loss of the excitation energy at the start of the Q-switched will become) , with the result that the peak power of the Q-switched pulsed laser beam (LB_{Q'}) will become lower.

In this embodiment, as will be described hereinbelow, the main control unit 28 measures the storage time T_{G} precedent to each modulation pulse MP₍ᵢ₎ on the basis of the reference pulse CP and counts the order of each reference pulse CP in a single equi-time-interval pulse train from the Q-switching control signal qc, thereby obtaining the degree of modulation [MD] in compliance with the measured or counted values of the storage time and the order. Then, the degree of modulation control signal mc in accordance with the thus obtained degree of modulation [MD] is imparted to the modulation pulse generation circuit 36 of the Q switch control unit 24 for generating therein the modulation pulse MP having an upslope gradient θ in compliance with the degree of modulation [MD].

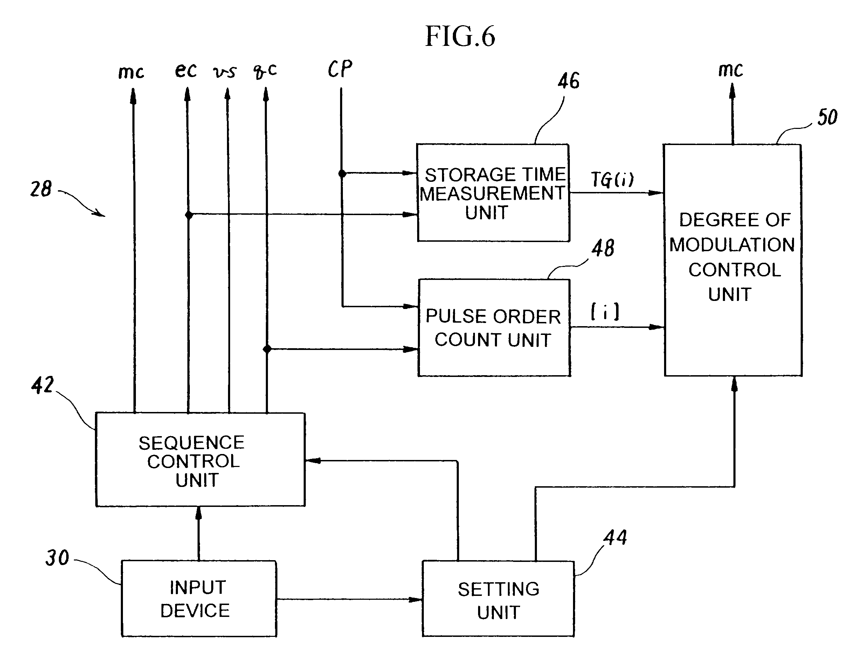

Fig. 6 shows a functional configuration within the main control unit 28 involved in the Q-switching modulation control of this embodiment.

In connection with the Q-switching modulation control of this embodiment, the main control unit 28 includes a sequence control unit 42, a setting unit 44, a storage time measurement unit 46 and a pulse order count unit 48 and a degree of modulation control unit 50.

The setting unit 44 holds various setting value data for marking processing entered through the input device 30. In conformity with marking plot data, setting values of marking speed and Q-switching frequency, etc., fed from the setting unit 44, the sequence control unit 42 imparts a Q-switching control signal qc and a repetition frequency control voltage vs to the pulse generator 32 within the Q switch control unit 24 and imparts a high-frequency oscillation control signal ec to the high-frequency oscillator 38.

The oscillation control signal ec is normally active (high) during the power-on, allowing the high-frequency oscillator 38 to successively issue the high-frequency electric signal ESₒ.

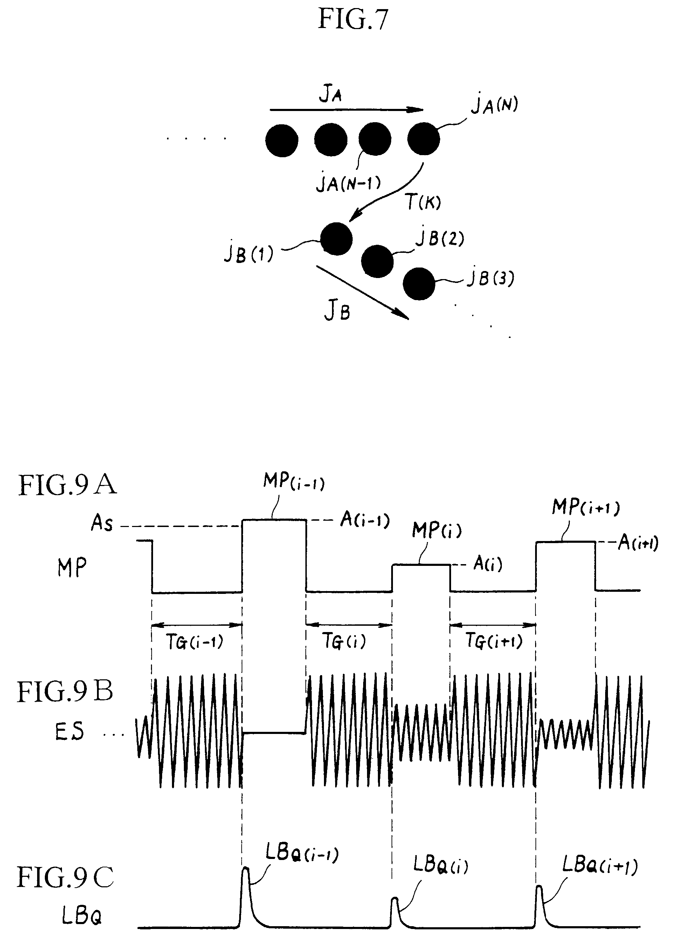

The Q-switching control signal qc goes normally active (high) for each marking period of one stroke (segment). For example, in cases where two consecutive strokes J_{A} and J_{B} are marked as shown in Fig. 7, the signal qc is kept high during the period when the stroke J_{A} is marked, permitting the reference pulse generator 32 to issue a pulse SP (i.e., to effect Q-switching) . Upon the completion of the marking of the stroke J_{A}, the signal qc goes temporarily low to interrupt the pulse SP (i.e., to cease the Q-switching), while simultaneously the scanning unit 22 causes the marking point to jump to the starting point of the next stroke J_{B}. Then, when the marking of the stroke J_{B} is commenced, the signal qc goes again high, allowing the output of the pulse SP (i.e., resumption of the Q-switching).

The frequency control voltage vs has a voltage level corresponding to the setting value of the Q-switching frequency. In one marking processing, the Q-switching frequency is normally set to a fixed value, so that the voltage level of the frequency control voltage vs is also kept at the setting level.

The storage time measurement unit 46 receives, as time measurement timing signals, a reference pulse CP from the pulse shaping circuit 34 of the Q switch control unit 24 and an oscillation control signal ec from the sequence control unit 42.

With respect to the reference pulse CP, detection is made of the leading start point and trailing end point of each pulse. Between two consecutive reference pulses CP_{(i - 1)} and CP₍ᵢ₎, measured as the storage time corresponding to the following pulse CP₍ᵢ₎ is the elapsed time TG₍ᵢ₎ from the pulse trailing end point of the preceding pulse CP_{(i - 1)} up to the pulse leading start point of the following pulse CP₍ᵢ₎.

Furthermore, as to the oscillation control signal ec, detection is made of the timing when the signal ec goes active (usually, immediately after the power-on or upon the initiation of the marking action) . The elapsed time TG₍₁₎ from the above detection point of time to the pulse leading edge of the first reference pulse CP₍₁₎ is measured as the storage time corresponding to the foremost reference pulse CP₍₁₎, the measurement data being output successively.

The pulse order count unit 48 accepts a reference pulse CP from the pulse shaping circuit 34 as a count object signal and accepts a Q-switching control signal qc from the sequence control unit 42 as a count period control signal.

Upon the initiation of one stroke marking, the Q-switching control signal qc rises from low to high, in response to which the pulse order count unit 48 starts counting the reference pulse CP. Subsequently, every time the reference pulse CP is accepted, the count value or the order value <i> is incremented by one, as <1>, <2>, <3>, <4>, ..., the count data being output successively. Then, upon the termination of one stroke marking, the Q-switching control signal qc falls from high to low, in response to which the pulse order count unit 48 completes a single counting action. Note that reset is performed at the start of or at the end of the counting.

The degree of modulation control unit 50 accepts storage time measurement data TG₍ᵢ₎ and order value count data <i> of each reference pulse CP₍ᵢ₎ fed respectively from the storage time measurement unit 46 and the pulse order count unit 48, and obtains the degree of modulation [MD] corresponding to that reference pulse CP₍ᵢ₎ through a calculation or through a lookup table on the basis of the above measured, counted values and a desired setting value (fixed value) from the setting unit 44. Then, a degree of modulation control signal mc corresponding to the thus obtained degree of modulation [MD] is fed to the modulation pulse generation circuit 36.

The modulation pulse generation pulse 36 in turn generates a modulation pulse MP having an upslope gradient θ in synchronism with that reference pulse CP₍ᵢ₎ from the pulse shaping circuit 34 and corresponding to the degree of modulation control signal mc from the degree of modulation control unit 50. Then, based on that modulation pulse MP the modulation circuit 40 modulates the amplitude of a high-frequency electric signal ESₒ to thereby generate a high-frequency electric signal ES which attenuates at an attenuation rate corresponding to the upslope gradient θ of the modulation pulse MP.

As described hereinabove, due to a variance in the amount of storage of the excitation energy at the time of Q-switched in the laser oscillation part, there may be a tendency of the peak power of the first Q-switched pulsed laser beam, a so-called first pulse LB_{Q(1)} or a second or third Q-switched pulsed laser beam LB_{Q(2)} or LB_{Q(3)}, immediately after the power-on or immediately after the restart of the Q-switching, toward an extraordinary protrusion as compared with the peak power in the steady state. In the case of the laser marking processing, it may result in an extraordinary thickness at the starting point of each stroke.

In this embodiment, the storage time measurement unit 46 measures the excitation energy storage time T_{G} elapsed till the initiation of each Q-switching in the laser oscillator 19. Using the value of this storage time T_{G} as a parameter and referring to the characteristic curve as indicated in Fig. 12, the degree of modulation control unit 50 executes a predetermined calculation or retrieves a predetermined lookup table so as to be able to obtain the degree of modulation with which is suppressed the peak power of the first pulse LB_{Q(1)} exceeding the saturation reference time T_{S}.

Even though the storage time T_{G} exceeds the saturation reference time T_{S}, the degree of modulation may variably be controlled in accordance with the length of the excess time. For instance, there may be defined second and third comparative reference times Tₐ and T_{b} which are longer than the saturation reference time T_{S} by predetermined times tₐ and t_{b} (tₐ < t_{b}), respectively, so that the degree of modulation can be set to different values for each of the cases ①T_{S} < T_{G} < Tₐ, ②Tₐ < T_{G} < T_{b} and ③T_{b} < T_{G}.

Thus, in the suppression of the peak power of the first pulse LB_{Q(1)}, when the storage time T_{G} is relatively long (case ③) due to the elapse of substantial time after power-on or to larger stroke spacings, the degree of suppression could be maximized by setting the degree of modulation or the upslope gradient θ to the minimum control value. On the contrary, when the storage time T_{G} slightly exceeds the reference time T_{S} (case ①) due to smaller stroke spacings, the degree of suppression could be weakened by setting the degree of modulation or the upslope gradient θ to a value larger than the minimum control value.

Furthermore, in this embodiment, the pulse order count unit 48 counts the order of each of the reference pulses CP₍₁₎, CP₍₂₎, ..., for each of a set of equi-time-interval pulses, that is, on a stroke basis in the marking processing. The degree of modulation control unit 50 is capable of providing a variable control of the degree of modulation for each pulse in such a manner that the parameter contains the value <i> of each order as well.

For example, in the case of the above ③, if the peak power of the first pulse LB_{Q(1)} is much suppressed to the level in the steady state, the remaining excitation energy, which could not been discharged thereat, is apt to migrate to the following second pulse LB_{Q(2)}, third pulse LB_{Q(3)}, etc. Therefore, the second pulse LB_{Q(2)}, third pulse LB_{Q(3)}, etc, may also be subjected to modulation control to suppress their respective peak powers with the appropriately reduced upslope gradient θ.

At that time, for the second pulse LB_{Q(2)}, third pulse LB_{Q(3)}, etc., as well, account may be taken of the storage time T_{G} derived from the storage time measurement time 46 or of the Q-switching frequency fed from the setting unit 44. More specifically, a shorter storage time T_{G} (or a higher Q-switching frequency) will result in a higher degree and a greater range of migration of the excitation energy from the first pulse LB_{Q(1)} to the pulses which follow.

It will be appreciated that the storage time T_{G} derived from the storage time measurement unit 46 is a parameter representative more precisely of the actual state of storage of the excitation energy than the Q-switching frequency fed from the setting unit 44.

Thus, by variably controlling in an appropriate manner the degree of modulation for the Q-switched pulsed laser beams LB_{Q(1)}, LB_{Q(2)}, LB_{Q(3)}, etc., having respective orders in accordance with a predetermined function or table, with the use as parameters of the storage time T_{G} from the storage time measurement unit 46 and the pulse order <i> from the pulse order count unit 48, it would be possible to allow their respective peak powers to substantially coincide with the peak power in the steady state.

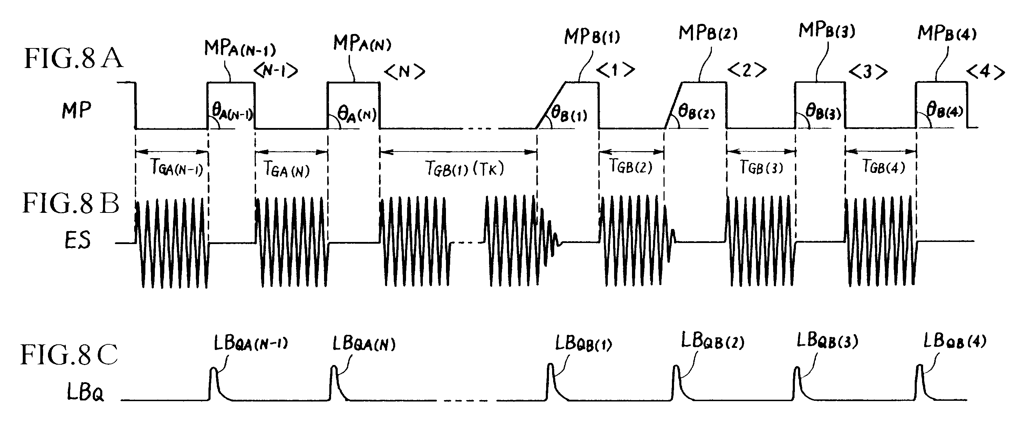

Figs. 8A to 8C illustrate, by way of example, waveforms which can appear at respective parts when two consecutive strokes J_{A} and J_{B} are marked as shown in Fig. 7 in this embodiment. In this example, the peak power suppressing control is provided to only the first pulse LB_{QB(1)} and the second pulse LB_{QB(2)} in the stroke J_{B}.

More specifically, the upslope gradient θ of the foremost modulation pulse MP_{B(1)} is made smaller considerably than the steady-state value (about 90 degrees) to thereby loosen the degree of modulation to a large extent so that the peak power of the first pulse LB_{QB(1)} is strongly suppressed. Furthermore, the upslope gradient θ of the second modulation pulse PM_{B(2)} is merely made smaller somewhat than the steady-state value to thereby loosen the degree of modulation to a small extent so that the peak power of the second pulse LB_{QB(2)} is weakly suppressed.

The upslope gradient θ of the third and subsequent pulses is fixed to the steady-state value (about 90 degrees) in order to cancel any suppression of the peak power.

The waveforms at the respective parts as illustrated in Figs. 8A to 8C, especially the waveforms of the modulation pulse MP and the high-frequency electric signal ES are controlled in compliance with the storage time T_{G(i)} and pulse order <i> associated with each modulation pulse MP₍ᵢ₎, by the storage time measurement unit 46, pulse order count unit 48 and degree of modulation control unit 50 within the main control unit 28 as set forth hereinabove.

In this manner, according to this embodiment, substantially the same peak power is imparted to each pulsed laser beam LB_{Q} in the laser marking whereby marking dots are formed to have substantially the same size within each stroke as shown in Fig. 7, to consequently achieve an improved marking quality.

It is to be appreciated that the above modulation control for imparting substantially the same peak power to each Q-switched pulsed laser beam LB_{Q} is merely one aspect or application of the solid-state laser apparatus of this embodiment. According to the Q-switching modulation control function of this embodiment, it would also be possible to individually control the degree of modulation on a pulse-to-pulse basis so that the peak power of each Q-switched pulsed laser beam LB_{Q} is variably controlled in an individual or independent manner.

In order to provide a variable control of the peak power of the Q-switched pulsed laser beam LB_{Q}, the above embodiment employs the method (Figs. 5A to 5C) in which the upslope gradient θ at the leading edge of the modulation pulse MP is variably controlled in compliance with the degree of modulation. For this reason, the modulation pulse generation circuit 36 in the Q switch control unit 24 is arranged to generate pulses for modulation MP in synchronism with the pulse CP from the pulse shaping circuit 34 and each having an upslope gradient θ in conformity with the degree of modulation control signal mc from the main control unit 28 (the degree of modulation control unit 50).

Instead, however, the modulation control similar to the above could also be implemented by using, as another basic modulation control method or peak power control method, a method in which variable control is applied to the amplitude level A of the modulation pulse MP in compliance with the degree of modulation as shown in Figs. 9A to 9C. In case of employing that method, the modulation pulse generation circuit 36 in the Q switch control unit 24 is arranged to generate pulses for modulation MP in synchronism with the pulse CP from the pulse shaping circuit 34 and each having an amplitude level A in compliance with the degree of modulation control signal mc from the main control unit 28 (the degree of modulation control unit 50). The other circuits such as the modulation circuit 40 have the same configurations as those in the above embodiment.

Referring to Figs. 9A and 9B, when the amplitude level A of the modulation pulse MP is higher than a predetermined threshold value A_{S}, the amplitude level of the high-frequency electric signal ES goes null during its off-period as a result of modulation of amplitude effected in the modulation circuit 40, allowing the Q-value of the laser oscillator 19 to return to its maximum. However, when the amplitude level A of the modulation pulse MP is lower than the threshold value A_{S}, the amplitude level of the high-frequency electric signal ES subjected to amplitude modulation by that modulation pulse MP cannot reach zero, resulting in incomplete off-state, whereupon the Q-value can but return to its intermediate value. This weakens the Q-switched pulse oscillation to suppress the peak power of the Q-switched pulsed laser beam LB_{Q}.

Although in the above embodiment the storage time measurement unit 46 and the pulse order count unit 48 in the main control unit 28 have accepted the reference pulse CP from the pulse shaping circuit 34 as the time measurement timing signal and the count object signal, respectively, the other pulses or signals having the same timings could also be received. For instance, the pulse SP issued from the pulse generator 32 may be imparted as the count object signal to the pulse order count unit 48.

Furthermore, although the accuracy of the modulation control might become lower than that in the above embodiment, it would also be possible for the degree of modulation control unit 50 to compute the degree of modulation on the basis of the storage time T_{G} from the storage time measurement unit 46, with the exclusion of the pulse order count unit 48.

The Q switch control unit 24 and the main control unit 28 may have variously modified configurations of their respective entireties or their respective constituent elements. The configuration of the laser oscillator 19 can also be modified in various manners. By way of example, the excitation lamp 12 could be replaced by a semiconductor laser. It will be appreciated that the YAG laser processing apparatus for laser marking of the above embodiment is a mere example and that the present invention is applicable to any Q-switched laser apparatuses.

## Claims

1. A Q-switched laser apparatus comprising:
a laser oscillator including a Q switch;
a power supply for supplying electric power for continuous oscillation to said laser oscillator;
high-frequency oscillation means for generating a high-frequency electric signal at a fixed frequency;
reference pulse generation means for generating a modulation reference pulse having a desired repetition frequency for modulating said high-frequency electric signal;
storage time measurement means for measuring, as excitation energy storage time for Q-switched pulse oscillation in said laser oscillator, the time during which said high-frequency electric signal keeps its amplitude at a steady level till the start of the pulse duration of a predetermined modulation reference pulse generated by said reference pulse generation means;
degree of modulation calculation means for computing the degree of modulation corresponding to said predetermined modulation reference pulse on the basis of the storage time measured by said storage time measurement means;
modulation means for modulating said high-frequency electric signal on the basis of said modulation reference pulse and in conformity with the degree of modulation computed by said degree of modulation calculation means; and
Q switch driver means for driving said Q switch in response to said modulated high-frequency electric signal, to cause said laser oscillator to oscillate and output a Q-switched pulsed laser beam in synchronism with said modulation reference pulse and having a peak power in conformity with said degree of modulation.

2. A Q-switched laser apparatus comprising:
a laser oscillator including a Q switch;
a power supply for supplying electric power for continuous oscillation to said laser oscillator;
high-frequency oscillation means for generating a high-frequency electric signal at a fixed frequency;
reference pulse generation means for generating a modulation reference pulse having a desired repetition frequency for modulating said high-frequency electric signal;
storage time measurement means for measuring, as excitation energy storage time for Q-switched pulse oscillation in said laser oscillator, the time during which said high-frequency electric signal keeps its amplitude at a steady level till the start of the pulse duration of a predetermined modulation reference pulse generated by said reference pulse generation means;
pulse order count means for counting the order of said predetermined modulation reference pulse in an equi-time-interval pulse train;
degree of modulation calculation means for computing the degree of modulation corresponding to said predetermined modulation reference pulse on the basis of the storage time measured by said storage time measurement means and of the order counted by said pulse order count means;
modulation means for modulating said high-frequency electric signal on the basis of said modulation reference pulse and in conformity with the degree of modulation computed by said degree of modulation calculation means; and
Q switch driver means for driving said Q switch in response to said modulated high-frequency electric signal, to cause said laser oscillator to oscillate and output a Q-switched pulsed laser beam in synchronism with said modulation reference pulse and having a peak power in conformity with said degree of modulation.

3. A Q-switched laser apparatus according to claim 1, wherein
said storage time measurement means include:
first timer means for measuring elapsed time from the feed starting point of said high-frequency electric signal up to the leading start point of a first fed pulse of said modulation reference pulsse; and
second timer means for measuring elapsed time, between two consecutive pulses of said modulation reference pulses being fed during the feed of said high-frequency electric signal, from the trailing end point of the preceding modulation reference pulse up to the leading start point of the following modulation reference pulse.

4. A Q-switched laser apparatus according to claim 2, wherein
said storage time measurement means include:
first timer means for measuring elapsed time from the feed starting point of said high-frequency electric signal up to the leading start point of a first fed pulse of said modulation reference pulses; and
second timer means for measuring elapsed time, between two consecutive pulses of said modulation reference pulses being fed during the feed of said high-frequency electric signal, from the trailing end point of the preceding modulation reference pulse up to the leading start point of the following modulation reference pulse.

5. A Q-switched laser apparatus according to claim 1, wherein
said modulation means include:
modulation pulse generation means for generating a modulation pulse in synchronism with said modulation reference pulse, said modulation pulse having at its leading edge an upslope gradient in conformity with said degree of modulation; and
amplitude modulation means for modulating the amplitude of said high-frequency electric signal by said modulation pulse.

6. A Q-switched laser apparatus according to claim 2, wherein
said modulation means include:
modulation pulse generation means for generating a modulation pulse in synchronism with said modulation reference pulse, said modulation pulse having at its leading edge an upslope gradient in conformity with said degree of modulation; and
amplitude modulation means for modulating the amplitude of said high-frequency electric signal by said modulation pulse.

7. A Q-switched laser apparatus according to claim 1, wherein
said modulation means include:
modulation pulse generation means for generating a modulation pulse in synchronism with said modulation reference pulse, said modulation pulse having an amplitude in conformity with said degree of modulation; and
amplitude modulation means for modulating the amplitude of said high-frequency electric signal by said modulation pulse.

8. A Q-switched laser apparatus according to claim 2, wherein
said modulation means include:
modulation pulse generation means for generating a modulation pulse in synchronism with said modulation reference pulse, said modulation pulse having an amplitude in conformity with said degree of modulation; and
amplitude modulation means for modulating the amplitude of said high-frequency electric signal by said modulation pulse.
